Europäisches Patentamt

European Patent Office

Office européen des brevets

(11) Numéro de publication : **0 053 067**
**B1**

(12) FASCICULE DE BREVET EUROPÉEN

(45) Date de publication du fascicule du brevet :
26.03.86

(21) Numéro de dépôt : 81401816.4

(22) Date de dépôt : 19.11.81

(51) Int. Cl.⁴ : **G 01 B 11/26, G 01 D 5/26,
G 08 C 23/00**

(54) **Dispositif de transmission de signaux électriques et de codage de position angulaire relative entre une pièce tournante et une pièce fixe.**

(30) Priorité : 21.11.80 FR 8024720

(43) Date de publication de la demande :
02.06.82 Bulletin 82/22

(45) Mention de la délivrance du brevet :
26.03.86 Bulletin 86/13

(84) Etats contractants désignés :
DE GB NL

(56) Documents cités :
GB-A- 1 576 006
GB-A- 2 007 355
US-A- 2 891 243

(73) Titulaire : Biolley, Alain
46 avenue Mozart
F-75016 Paris (FR)

(72) Inventeur : Biolley, Alain
46 avenue Mozart
F-75016 Paris (FR)

(74) Mandataire : Chêne, Philippe et al
BUREAU DES BREVETS ET INVENTIONS DE LA
DELEGATION GENERALE POUR L'ARMEMENT
(DPAG) 26, Boulevard Victor
F-75996 Paris Armées (FR)

## Description

La présente invention concerne un dispositif assurant à la fois la transmission de signaux électriques et le codage de position angulaire relative entre une pièce tournante et une pièce fixe, notamment pour radar.

Une installation de radar pose le problème de la transmission de signaux électriques entre la partie tournante de l'installation, qui comprend notamment l'antenne, et l'infrastructure fixe, qui comprend notamment les organes de visualisation.

Dans le domaine des installations radar, il est connu de réaliser cette transmission au moyen d'un joint tournant coaxial à contact physique, à bague et charbons. Toutefois, ce système présente un certain nombre d'inconvénients. Outre une fabrication délicate et coûteuse, le système occupe en effet la partie centrale du joint et interdit d'utiliser comme support un mât existant. On utilise donc une plate-forme désaxée, ce qui peut conduire à des zones d'ombre portée par le mât qui la supporte.

D'autre part, si l'on utilise, pour montage autour d'un mât, une antenne en deux parties pouvant être disjointes l'une de l'autre, l'existence d'un plan de joint dans la bague interdira pratiquement la transmission correcte des signaux.

Dans d'autres domaines techniques on connaît, par exemple par les brevets anglais GB-A-1 576 006, et GB-A-2 007 355, des dispositifs de transmission de signaux électriques entre une pièce tournante et une pièce fixe. Ces dispositifs comprennent des moyens d'émission, consistant en une source lumineuse modulée, sur l'une des pièces, et des moyens de réception, consistant en détecteurs photo-sensibles, sur l'autre pièce. Ces derniers sont disposés pour passer lors de la rotation à portée de réception du signal lumineux émis. Un dispositif possédant toutes les caractéristiques non facultatives qui figurent dans le préambule de la revendication 1, est connu du brevet GB-A-2 007 355.

La présente invention vise à utiliser un dispositif de transmission de ce type qui n'encombre pas la partie axiale et permette ainsi le montage autour d'un mât, tout en ménageant un passage des signaux sans altération.

Selon l'invention, le dispositif assurant à la fois la transmission de signaux électriques et le codage de position angulaire relative entre une pièce tournante et une pièce fixe, notamment pour installation de radar, le dispositif de transmission comprenant sur l'une des pièces, des moyens d'émission et, sur l'autre pièce, des moyens de réception coopérant avec lesdits moyens d'émission, les moyens d'émission servant également au codage comprenant au moins une source lumineuse modulée connectée à une source de signaux, et les moyens de réception servant également au codage comprenant au moins deux éléments photo-sensibles dont les positions angulaires sont prédéterminées sur la pièce qui les porte et situés de manière à passer au cours de leur trajectoire, à portée de réception du signal lumineux de la source précitée et connectés à un circuit de traitement des signaux transmis, est caractérisé en ce que les moyens de réception servant également au codage comprennent un ensemble de plusieurs photo-diodes présentant une répartition angulaire régulière le long de la périphérie de la pièce qui les porte, le circuit de traitement des signaux transmis prenant en compte la modulation d'amplitude de ces signaux pour la détermination de la position angulaire de la pièce tournante.

La suppression de la transmission par contact physique permet une construction à la fois moins onéreuse et plus fiable. En outre les éléments sensibles sont placés à la périphérie des pièces, ce qui permet le montage autour d'un axe creux. Enfin, plusieurs dispositifs superposés peuvent être installés, car on peut facilement les réaliser en parties séparables pour le montage autour d'un axe. De plus, l'une au moins des photo-diodes ne se trouve pas dans l'obscurité. On évite ainsi le bruit d'obscurité, et le signal présente constamment une composante continue.

Suivant une réalisation avantageuse de l'invention, les moyens d'émission servant également au codage comprennent plusieurs diodes électro-luminescentes réparties sur la périphérie de la pièce qui les porte.

Pour supprimer, ou au moins réduire fortement le bruit d'obscurité des photos-diodes, on est amené à limiter leur nombre. On doit alors, pour enrichir l'information transmise, multiplier le nombre de diodes électroluminescentes émettrices.

De préférence, les diodes électro-luminescentes sont régulièrement espacées et situées à l'intérieur d'un secteur prédéterminé correspondant à l'écart angulaire entre deux photo-diodes voisines.

Quand une photo-diode sort du secteur des diodes électro-luminescentes, la suivante y entre.

Cette disposition permet un codage de la position angulaire des pièces mécaniques, l'une supportant la source d'information (une antenne) et l'autre recevant l'information en vue de sa visualisation.

Suivant une réalisation perfectionnée de l'invention, les moyens de réception servant également au codage comprennent un second ensemble de photo-diodes régulièrement espacées sur la périphérie de la pièce qui les porte, ce second ensemble étant décalé d'un angle prédéterminé par rapport au premier ensemble.

Les moyens de codage d'angle définis plus haut sont alors réalisés sous la forme d'un vernier améliorant considérablement la définition de la position angulaire relative des deux pièces.

Suivant une autre réalisation de l'invention le dispositif utilisé dans une installation de radar, un système de génération, d'émission, de réception et de traitement des signaux en hyperfréquence, moyenne fréquence et vidéo est solidaire de la pièce tournante du dispositif de transmission, de sorte que seul le signal vidéo transite par ce dispositif, à l'exclusion des signaux en hyperfréquence.

Le dispositif comprend alors avantageusement un contact sensible au mouvement de la pièce tournante pour couper transitoirement l'alimentation des diodes électro-luminescentes quand l'émission radar passe par une direction prédéterminée liée à la partie fixe.

On obtient ainsi un signal de passage de l'antenne par l'axe de cap.

D'autres particularités et avantages de l'invention ressortiront encore de la description détaillée qui va suivre.

Aux dessins amenés, donnés à titre d'exemple non limitatif :

la figure 1 est une vue schématique d'ensemble d'une installation de radar utilisant un dispositif de transmission conforme à l'invention,

la figure 2 est une vue en plan, avec arraché partiel, du dispositif de transmission,

la figure 3 est une vue en coupe éclatée suivant III-III de la figure 2,

la figure 4 est une vue en plan suivant IV-IV de la figure 1,

la figure 5 est un diagramme typique des signaux reçus à la sortie des diodes de réception lumineuse,

la figure 6 est une vue schématique en plan du dispositif montrant une variante de répartition des diodes émettrices et réceptrices.

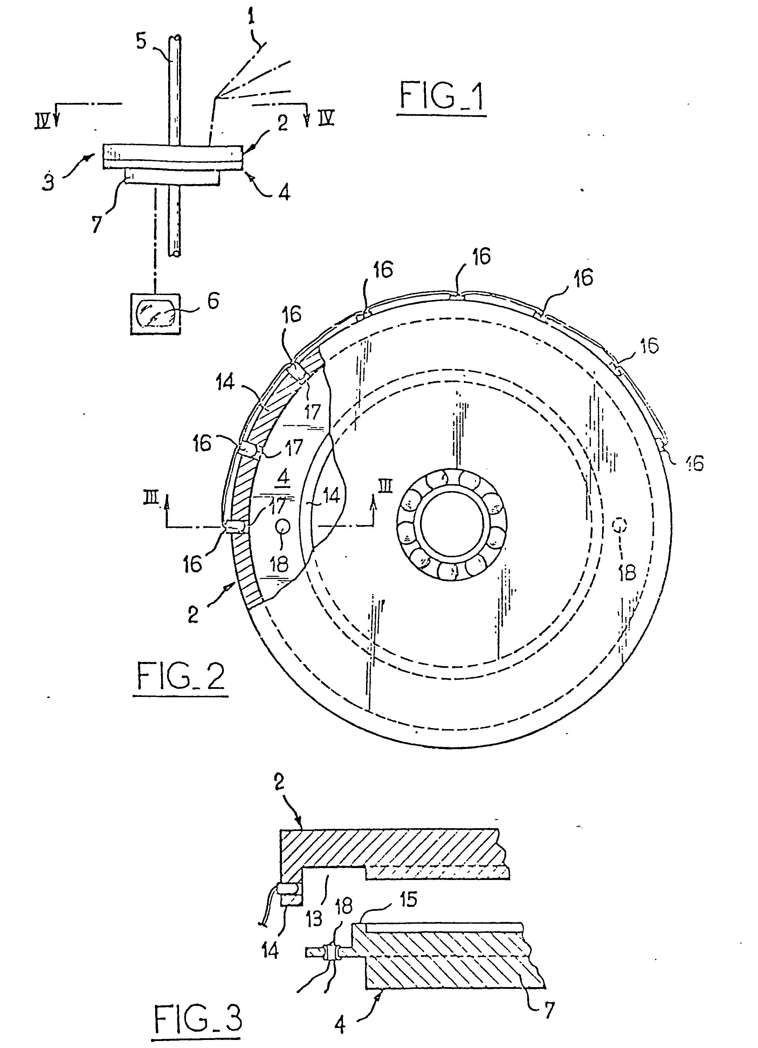

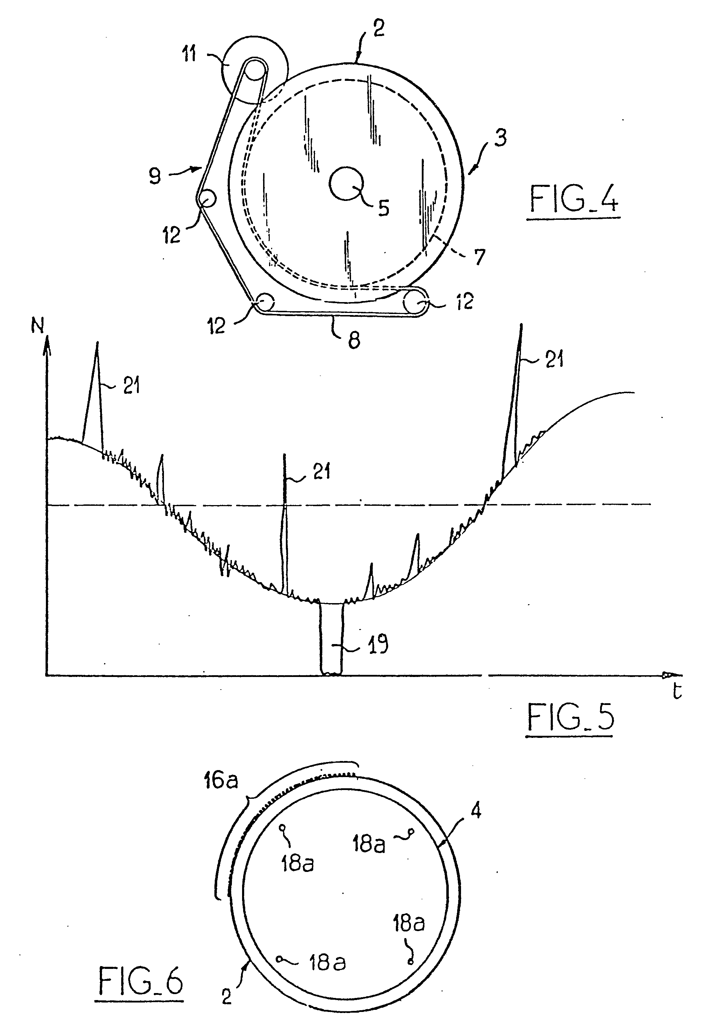

En référence aux figures 1 et 4, une installation de radar comprend une antenne 1 fixée à une pièce tournante 2 d'un dispositif de transmission 3 qui comprend également une pièce fixe 4 montée autour du mât 5 d'un navire et reliée à un dispositif de visualisation 6.

La pièce fixe 4 présente une portée circulaire 7 coaxiale au mât pour coopérer avec une courroie 8 d'un système d'entraînement 9 solidaire de la pièce tournante 2.

Ce système d'entraînement comprend un moteur électrique 11 et un certain nombre de poulies 12 sur lesquelles s'appuie la courroie 8. Cette courroie, de préférence crantée, s'appuie sur la portée 7 par l'extérieur de sa boucle, de sorte que le mât 5 se trouve à l'extérieur de cette boucle, ce qui rend possible le montage sans avoir à passer le sommet du mât.

En référence aux figures 2 et 3, la pièce tournante 2 présente une gorge circulaire 13 limitée à l'extérieur par un rebord 14. Cette gorge est prévue pour recevoir une saillie circulaire de centrage 15 de la pièce fixe 4. Cette saillie n'occupe que partiellement la gorge 13, de sorte que, une fois les pièces assemblées il subsiste une cavité circulaire formée par la partie non occupée de la gorge 13.

Sur une partie de la périphérie de la pièce tournante 2, des diodes électro-luminescentes 16 sont encastrées dans des trous 17 qui traversent le rebord 14 et convergent vers l'axe de rotation, de manière qu'elles puissent éclairer la gorge 13.

Ces diodes, que l'on appellera émettrices dans ce qui suit, par abréviation, sont montées en série et reliées à la sortie des étages auxiliaires de l'antenne 1. Ces étages comprennent des dispositifs (non représentés) de réception et de traitement des signaux en hyperfréquence et fréquences intermédiaires et délivrent un signal vidéo qui est appliqué aux diodes émettrices.

Deux photo-diodes réceptrices 18 sont encastrées dans la pièce fixe 4 à la hauteur de la gorge 13 pour passer à portée de réception des diodes émettrices 16. Ces photo-diodes, diamétralement opposées et montées en série, sont reliées à l'étage de visualisation 6.

Enfin, un contact (non représenté) sensible au mouvement de la pièce tournante est prévu pour couper transitoirement l'alimentation des diodes émettrices à chaque tour de l'antenne.

Dans l'exemple décrit, ce contact est prévu pour fonctionner quand l'antenne passe par l'axe de cap du navire.

Quand l'antenne tourne, une photo-diode passe successivement devant les diodes émettrices et transmet le signal vidéo à l'étage de visualisation. Le secteur où sont situées les diodes émettrices est déterminé de manière que, quand la photo-diode précitée quitte la dernière diode émettrice, l'autre photo-diode arrive devant la première diode émettrice.

L'espacement entre les diodes émettrices est déterminé de manière que les photo-diodes soient toujours suffisamment éclairées pour délivrer un signal se situant nettement au-dessus du bruit d'obscurité.

On a représenté sur la figure 5 le niveau N du signal transmis en fonction du temps t entre les passages d'une photo-diode devant deux diodes émettrices consécutives.

L'éclairement reçu passe par un minimum situé entre deux maxima correspondant aux passages devant les diodes émettrices. La prise en compte de la distance séparant ces maxima fournit un moyen de codage de l'angle de rotation de l'antenne. Le niveau N est toujours nettement positif et ne s'annule qu'en 19, où l'on suppose que l'alimentation des diodes émettrices a été coupée pour fournir l'indication du passage par l'axe de cap du navire.

Le signal transmis présente des pics 21 correspondant à l'émission radar (dite « kilomètre zéro »), les autres pics correspondant aux échos.

Dans une réalisation plus perfectionnée de l'invention, (figure 6), on a prévu 45 diodes émettrices 16a réparties sur un secteur de 90° de la pièce tournante, et quatre photo-diodes 18a disposées en carré. Dans ces conditions, le codage d'angle de l'antenne s'effectue avec une définition de deux degrés.

On peut encore améliorer cette définition en prévoyant un second ensemble (non représenté) de quatre photo-diodes également disposées en carré et décalé d'un nombre impair de degrés par rapport à l'ensemble des diodes 18a. On obtient alors une définition d'un degré.

Les deux pièces respectivement tournante et fixe, peuvent facilement être réalisées en deux parties. Il en est de même de l'antenne, notamment si celle-ci est conforme à celle décrite dans la demande de brevet français FR-A-2 490 883, publiée le 26 mars 1982. Si l'on se réfère à ce qui a été dit au sujet du système d'entraînement 9, on voit que l'ensemble peut être monté autour d'un mât sans avoir à passer par son sommet. On peut ainsi, notamment monter plusieurs systèmes étagés sur un même mât.

A cet avantage s'ajoutent ceux d'une fabrication économique et d'une très grande fiabilité. Il est d'autre part évident que le mât ne constitue pas une zone d'ombre.

L'alimentation en puissance de l'antenne peut sans inconvénient être réalisée par l'intermédiaire d'un joint tournant classique à contact physique.

Bien entendu, l'invention n'est pas limitée aux exemples décrits mais couvre toute variante à la portée de l'homme de l'art. Par exemple, les photo-diodes peuvent être montées en parallèle.

## Revendications

1. Dispositif assurant à la fois la transmission de signaux électriques et le codage de position angulaire relative entre une pièce tournante (2) et une pièce fixe (4), notamment pour installation de radar, le dispositif de transmission comprenant sur l'une des pièces, des moyens d'émission et, sur l'autre pièce, des moyens de réception coopérant avec lesdits moyens d'émission, les moyens d'émission servant également au codage comprenant au moins une source lumineuse modulée (16) connectée à une source de signaux, et les moyens de réception servant également au codage comprenant au moins deux éléments photo-sensibles (18) dont les positions angulaires sont prédéterminées sur la pièce qui les porte et situés de manière à passer au cours de leur trajectoire, à portée de réception du signal lumineux de la source précitée (16) et connectés à un circuit de traitement (6) des signaux transmis, dispositif caractérisé en ce que les moyens de réception servant également au codage comprennent un ensemble de plusieurs photo-diodes (18) présentant une répartition angulaire régulière le long de la périphérie de la pièce (4) qui les porte, le circuit de traitement des signaux transmis prenant en compte la modulation d'amplitude de ces signaux pour la détermination de la position angulaire de la pièce tournante (2).

2. Dispositif conforme à la revendication 1, caractérisé en ce que les moyens d'émission servant également au codage comprennent plusieurs diodes électro-luminescentes (16) réparties sur la périphérie de la pièce (2) qui les porte.

3. Dispositif conforme à la revendication 2, caractérisé en ce que les diodes électro-luminescentes (16a) sont régulièrement espacées et situées à l'intérieur d'un secteur prédéterminé correspondant à l'écart angulaire entre deux photo-diodes (18a) voisines.

4. Dispositif conforme à la revendication 3, caractérisé en ce que les moyens de réception servant également au codage comprennent un second ensemble de photo-diodes régulièrement espacées sur la périphérie de la pièce qui les porte, ce second ensemble étant décalé d'un angle prédéterminé par rapport au premier ensemble.

5. Dispositif conforme à l'une des revendications 1 à 4, caractérisé en ce qu'il utilise dans une installation de radar, un système de génération, d'émission, de réception et de traitement des signaux en hyperfréquence qui est solidaire de la pièce tournante (2) du dispositif de transmission.

6. Dispositif conforme à la revendication 5, caractérisé en ce qu'il comprend un contact sensible au mouvement de la pièce tournante (2) pour couper transitoirement l'alimentation des diodes électro-luminescentes quand l'émission radar passe par une direction prédéterminée liée à la partie fixe (4).

## Claims

1. Apparatus both transmitting electric signals and encoding the relative angular position between rotating part (2) and fixed part (4), in particular for a radar system, the transmitting apparatus including transmission facilities on one of the parts and reception facilities cooperating with said transmission facilities on the other part, the transmission facilities also being used for encoding including at least one modulated light source (16) connected to a signal source and the reception facility, also used for encoding, including at least two photosensitive elements (18) whose angular positions are predetermined on the part bearing them and located so as to pass, during their path, within reception range with the light signal of said source (16) and connected to a circuit (6) processing the transmitted signals, apparatus in which the reception facilities also used for encoding include an array of several photodiodes (18) distributed at evenly spaced angles on the edge of part (4) bearing them, the transmitted signal processing circuit taking into account the amplitude modulation of the signals for determination of the angular position of rotating part (2).

2. Apparatus as per claim 1, in which the transmission facilities also used for encoding include several light-emitting diodes (16) distributed on the edge of part (2) bearing them.

3. Apparatus as per claim 2, in which light-emitting diodes (16a) are evenly spaced and located in a predetermined sector corresponding to the angular spacing between two adjacent photodiodes (18a).

4. Apparatus as per claim 3, in which the reception facilities also used for encoding include a second array of evenly spaced photodiodes on the edge of the part bearing them, this second array being offset by a predetermined angle with respect to the first array.

## Patentansprüche

5. Apparatus as per one of claims 1 to 4 which uses, in a radar system, a microwave signal generation, transmission and reception system integral with rotating part (2) of the transmission apparatus.

6. Apparatus as per claim 5, which includes a contact sensitive to the movement of rotating part (2) to momentarily cut off power supply to the light-emitting diodes when the radar transmission crosses a predetermined direction in relation to fixed part (4).

**Patentansprüche**

1. Vorrichtung zur Uebertragung elektrischer Signale und zugleich zur Codierung der verhältnismässigen Winkellage zwischen einem drehenden Element (2) und einem festen Element (4), insbesondere für die Ausrüstung einer Radaranlage, auf welcher das Uebertragungsglied auf dem einen Element Sendemittel und auf dem anderen Element Empfangsmittel, die mit den erwähnten Sendemitteln mitwirken, einsetzt, und die auch zur Codierung dienenden Sendemittel mindestens eine aus einer Signalquelle gesteuerte, modulierte Lichtquelle (16) aufweisen sowie die auch zur Codierung dienenden Empfangsmittel mindestens zwei lichtempfindliche Elemente (18) aufweisen, dessen winkelmässige Lage auf dem tragenden Element vorbestimmt ist, die so angeordnet sind, daß sie auf ihrer Laufbahn im Empfangsbereich des Lichtsignals der erwähnten Lichtquelle (16) geraten, und die mit einem Schaltkreis (6) zur Verarbeitung der übertragenen Signale verbunden sind, Vorrichtung dadurch gekennzeichnet, daß die Empfangsmittel, die zugleich die Codierung übernehmen, aus einem Satz mehrerer Fotodioden (18), die in regelmässigen Abständen auf dem Umkreis des tragenden Werkstückes (4) angeordnet sind, sowie aus einem Schaltkreis für die Verarbeitung der übertragenen Signale, der aus der Amplitudenmodulation dieser Signale die Winkellage des rotierenden Elementes (2) ermittelt, bestehen.

2. Vorrichtung nach Anspruch 1, dadurch gekennzeichnet, daß die auch zur Codierung eingesetzten Sendemittel aus mehreren, auf dem Umkreis des Elements (2) verteilten Leuchtdioden (16) bestehen.

3. Vorrichtung nach Anspruch 2, dadurch gekennzeichnet, daß die Leuchtdioden (16a) in regelmässigen Abstand und in einem festgelegten, dem Abstand zwischen zwei benachbarten Fotodioden (18a) entsprechenden Winkelbereich angeordnet sind.

4. Vorrichtung nach Anspruch 3, dadurch gekennzeichnet, daß die auch zur Codierung eingesetzten Empfangsmittel aus einem zweiten Satz von regelmässig auf dem Umkreis des tragenden Elementes angeordneten Fotodioden besteht, wobei dieser zweiter Satz um einen festgelegten Winkel gegenüber dem ersten Satz versetzt ist.

5. Vorrichtung nach einem beliebigen Anspruch 1 bis 4, dadurch gekennzeichnet, daß sie in einer Radaranlage ein Signalgeber-, Sende-, Empfangs- und hyperfrequentes Signalverarbeitungssystem einsetzt, das auf dem rotierenden Element (2) des Uebertragungssystems angeordnet ist.

6. Vorrichtung nach Anspruch 5, dadurch gekennzeichnet, daß sie einen Kontakt ausweist, der auf die Bewegung des rotierenden Elementes (2) anspricht, um die Stromversorgung der Leuchtdioden vorübergehend zu unterbrechen, wenn die Hauptkeule des Radars in einem bestimmten Winkelbereich gegenüber dem festen Element (4) gerichtet ist.

FIG_1

FIG_2

FIG_3

FIG_4

FIG_5

FIG_6